# EUROPEAN PATENT SPECIFICATION

(11) **EP 2 260 555 B1**
(45) Date of publication and mention of the grant of the patent: **31.08.2011**
(21) Application number: 08706946.4
(22) Date of filing: 29.02.2008
(51) Int. Cl.: H02G 13/00

(54) **WIND TURBINE WITH LOW ELECTROMAGNETIC RADIATION**
WINDTURBINE MIT GERINGER ELEKTROMAGNETISCHER STRAHLUNG
ÉOLIENNE À FAIBLE RAYONNEMENT ÉLECTROMAGNÉTIQUE

(43) Date of publication of application: 15.12.2010
(73) Proprietor: Vestas Wind Systems A/S, 8940 Randers - SV (DK)
(72) Inventor: NIEUWENHUIZEN, John, DK-8700 Horsens (DK)
(74) Representative: Plougmann & Vingtoft A/S
(86) International application number: PCT/DK2008/050052
(87) International publication number: WO 2008/092464

(56) References cited:
- EP-A- 0 583 809
- WO-A-2005/050008
- WO-A-2007/107158
- DE-U1-202007 009 915
- US-A- 5 346 410
- US-A- 5 530 634

## Description

### FIELD OF THE INVENTION

The present invention relates to the field of wind turbines. More specifically, the invention relates to a wind turbine with a low electromagnetic radiation.

### BACKGROUND OF THE INVENTION

Wind turbines are normally equipped with lightning arrester arrangements serving to conduct an electric discharge from a lightning striking the wind turbine to electrical ground without any permanent damage. Typically lightning receptors are positioned on the blades to catch a lightning, and via a down conductor system the lightning receptors are connected to electrical ground, e.g. in the form of an earth rod at the base of the wind turbine tower. Such lightning arrester arrangements can ensure efficient lightning protection of the wind turbine.

In typical wind turbines the blades are rotatably mounted to the hub, the hub is rotatably mounted in relation to the nacelle, and finally the nacelle is rotatably mounted to the tower. Thus, the down conductor arrangement includes a number of sliding contacts, either in the form of brushes or trolley shoe/rail arrangements, to ensure electric connection across these rotatable mountings. Correctly dimensioned, such sliding contacts function reliably in conducting the rather high currents when lightning strikes. Such a device is disclosed in WO 2005/050008.

However, sliding contacts do not necessarily provide a completely continuous electric connection, but rather the connection typically suffers from very short abruptions. This means that electric charges due to static electricity caused by the passage of the blades by the tower are not effectively grounded. Thus, in short periods with poor or no electric connection in the sliding contact, static electric charges can build up and due to the very high voltages, sparks can be created in the down conductor. Such sparks result in short high voltage pulses being transmitted in the down conductor meaning that wide band electromagnetic radiation (EM) energy is radiated from the down conductor. With the large dimension of the down conductor, especially the electrical conductor parts in the blades, the wind turbine can act as a large antenna, and under certain conditions a substantial amount of high frequency EM energy can be radiated from the wind turbine. Especially the frequency range 1-100 MHz is problematic with respect to such EM noise, since this range also serves for numerous wireless communication channels, and thus noise in this range can cause severe disturbance.

EP-A 0 583 809 discloses the use of ferrous electromagnetic radiation suppression filters on electrical components. WO 2007/107158 A addresses the problem of electromagnetic radiation suppression on the generator shaft of a wind turbine by means of capacitances connected thereto, thereby preventing the shaft from acting like an antenna.

### SUMMARY OF THE INVENTION

Thus, according to the above description, one object of the present invention is to provide a wind turbine with reduced EM radiation.

The invention provides a wind turbine having the features of claim 1 including
- one or more rotor blades arranged for rotation in relation to a nacelle,
- a tower arranged for carrying the nacelle, and
- a lightning arrester system including
   - one or more lightning receptors mounted on the one or more rotor blades,
   - a down conductor arranged for electrically connecting the one or more lightning receptors to electrical ground, the down conductor including a first sliding contact arrangement, and
   - an EM radiation reduction device encircling a portion of the down conductor so as to reduce, EM radiation from the down conductor.

By 'EM radiation reduction (EMRR) device' is understood a device arranged to magnetically absorb or choke EM radiation due to electrical pulses in the down conductor.

A wind turbine according to the invention solves the problem of EM radiation from the lighting arrester down conductor due to static electric charges causing the sliding contact arrangement to create sparks. The EMRR device serves to reduce transmission of the spark on the down conductor and thereby reduces EM radiated from the down conductor of the wind turbine.

In addition to EM radiation caused by sparks due to static electric charges, the EMRR device has a further EM radiation reducing effect. The presence of the EMRR device serves to destroy the ability of the down conductor to act as a Radio Frequency (RF) receiving antenna because the EMRR device will change the impedance of the down conductor. Thus, EM radiation from the down conductor due to RF signals being received from external transmitters will also be reduced by the EMRR device.

The solution is advantageous since it is rather easy to install EMRR devices on electrical conductor parts of the down conductor, e.g. in the form of common mode choke coils or solid body type chokes on electrical conductor parts of the down conductor. In wind turbines with a down conductor including two or three sliding contact arrangements, EMRR devices may be installed in connection with one, two or three of the sliding contact arrangements successively to reduce EM radiation to a desired level, e.g. a level set by standards. EMRR devices fitting the size of typical electrical conductor parts of the down conductor are standard components, and thus altogether it is possible to reduce EM radiation from existing wind turbines at a low cost and within a limited shut down period.

Since the EMRR devices are not in electrical connection with the down conductor, they do not affect the ability of the down conductor in conducting high electrical currents during strike of lightning.

In the following, preferred embodiments will be described.

In preferred embodiments, the wind turbine includes a plurality of separate EMRR devices encircling different portions of the down conductor. The effective EM reduction effect is determined partly by the portion of the down conductor encircled by EMRR devices. However, the most effective use of EMRR devices to reduce transmission of electric impulses on the down conductor is to arrange EMRR devices on an end part of an electrical conductor part of the down conductor facing the first sliding contact arrangement. Hereby the electric impulses are blocked close to their origin, namely at the sliding contact arrangement. Thus, it is preferred to have at least one EMRR device arranged on an electrical conductor part of the down conductor as close to the sliding contact arrangement as possible.

The EMRR device may alternatively or additionally include a coil with a plurality of windings arranged for encircling a portion of the down conductor. Such coil may include a plurality of windings arranged as layers around the portion of the down conductor. Further, a combination of solid body devices or coils may be used to increase the EMRR effect over a desired frequency range, utilizing the different properties of solid body devices and coils.

In embodiments including a plurality of separate EMRR devices, at least two different types of EMRR devices with different EMRR properties may be used, e.g. a combination of coils and solid bodies mounted close to each other. Hereby it is possible e.g. to combine the different EMRR properties to obtain a large EM radiation attenuation covering a desired frequency range, since some type of EMRR devices are most effective in a rather narrow frequency range.

In preferred embodiments, the down conductor includes a first electrical conductor part arranged in a rotor blade, the first electrical conductor part interconnecting the one or more lightning receptors and the first sliding contact arrangement for electrically connecting the first electrical conductor part to a second electrical conductor part, and wherein a first EM reduction device encircles a portion of the first electrical conductor part, preferably an end portion of the first electrical conductor part facing the first sliding contact arrangement. The first sliding contact may serve to provide a rotatable electrical interconnection between the blade and hub/spinner. Typically, the largest part of EM radiated from the down conductor in a wind turbine is radiated from the down conductor parts in the blades, and therefore it is of high priority to install an EM reduction device to reduce EM radiation from electrical conductor parts in the blades. Thus, preferably an EM reduction device is installed on down conductor parts in all blades of the wind turbine. A second EMRR device may be mounted on the second electrical conductor part, preferably at an end portion of the second electrical conductor part facing the first sliding contact arrangement.

Some embodiments include a second sliding contact arrangement interconnecting the second electrical conductor part and a third electrical conductor part of the down conductor, wherein an EMRR device is mounted on the third electrical conductor part, preferably at an end portion of the third electrical conductor part facing the second sliding contact arrangement. The second sliding contact arrangement can serve to provide a rotatable electrical interconnection between the hub/spinner and the nacelle.

Some embodiments include a third sliding contact arrangement interconnecting the third electrical conductor part and a fourth electrical conductor part of the down conductor, wherein an EMRR device is mounted on the fourth electrical conductor part, preferably at an end portion of the fourth electrical conductor part facing the third sliding contact arrangement. The second sliding contact arrangement can serve to provide a rotatable electrical interconnection between the nacelle and the tower.

For optimum EM reduction, at least one EMRR device is mounted on electrical conductor parts facing all sliding contact arrangements in the down conductor.

The first sliding contact arrangement may include two sliding contacts interconnected by an intermediate electrical conductor part, and wherein an EMRR device encircles the intermediate electrical conductor part. More specifically, the two sliding contacts may each include a rail and a trolley shoe forced into contact with each other by a spring member, so as to provide electrical contact between the rail and the trolley shoe. In these embodiments, an electrical conductor part of the sliding contact arrangement is utilized to introduce further EM radiation reduction which is rather effective, since it is positioned very close to the actual contact part where sparks are generated. Further, the intermediate electrical conductor part may be easy to dismantle and thus easy to provide with solid body and coil type EMRR devices. Especially, for add-on on an existing wind turbine, such intermediate electrical conductor part may be easily replaced by another and longer intermediate electrical conductor part, thus enabling the intermediate electrical conductor part to be looped once or more times around and passing through respective through-going holes in EMRR devices, such as solid body and/or coil types, thereby obtaining an increased EM reduction effect compared to the EMRR device merely encircling the intermediate electrical conductor part once.

In general, to increase the EM reduction effect, the down conductor may be looped a plurality of times around EMRR device, the down conductor passing around a portion of and through a through-going hole in the MRR device, such that the EMRR encircles a plurality of portions of the down conductor. Hereby a larger portion of the conductor is encircled by the EMRR device, and thus a better utilization of the EMRR is obtained, that would otherwise require mounting of several EMRR devices of the same type. Especially, the down conductor may be looped a plurality of times around a plurality of electromagnetic radiation reduction devices, the down conductor passing around a portion of and through respective through-going holes in said plurality of electromagnetic radiation reduction devices. Even more specifically, such plurality of EMRR devices may include at least two EMRR devices with different EM reduction properties.

In a second aspect, the invention provides a method according to claim 13 of reducing electromagnetic radiation from a wind turbine, where the wind turbine includes at least two rotor blades arranged for rotation in relation to a nacelle, a tower arranged for carrying the nacelle, and a lightning arrester system including one or more lightning receptors mounted on the one or more rotor blades as well as a down conductor arranged for electrically connecting the one or more lightning receptors to electrical ground, and where the down conductor includes a sliding contact arrangement, wherein the method includes arranging an electromagnetic radiation reduction device relative to the down conductor so that at least a portion of the down conductor is encircled by the electromagnetic radiation device.

Especially, the electromagnetic radiation reduction device may be arranged to encircle a portion of the down conductor, said portion being located adjacent to the sliding contact arrangement.

It is appreciated that the embodiments and advantages mentioned for the first aspect apply as well for the third aspect.

### BRIEF DESCRIPTION OF THE FIGURES

The invention will now be described in more detail with regard to the accompanying figures of which
Fig. 1 illustrates a sketch of basic elements of the invention,
Fig. 2 illustrates a cross section view and a section view of a cylindrically shaped EM reduction device mounted on an electrical conductor part of a down conductor,
Fig. 3 illustrates a sketch of a wind turbine blade with an EMRR device mounted on an internal down conductor part,
Fig. 4 illustrates a sketch of a wind turbine down conductor system with three sliding contact arrangements and possible positions of EM reduction devices in relation thereto,
Fig. 5 illustrates a detail of an EMRR device mounted on an intermediate piece of electrical conductor forming part of a sliding contact arrangement, and
Fig. 6 shows a photo of an intermediate piece of electrical conductor looped inside a plurality of cylindrically shaped EMRR devices.

The figures specifically illustrate ways of implementing the present invention and are not to be construed as being limiting to other possible embodiments falling within the scope of the attached claim set.

### DETAILED DESCRIPTION OF AN EMBODIMENT

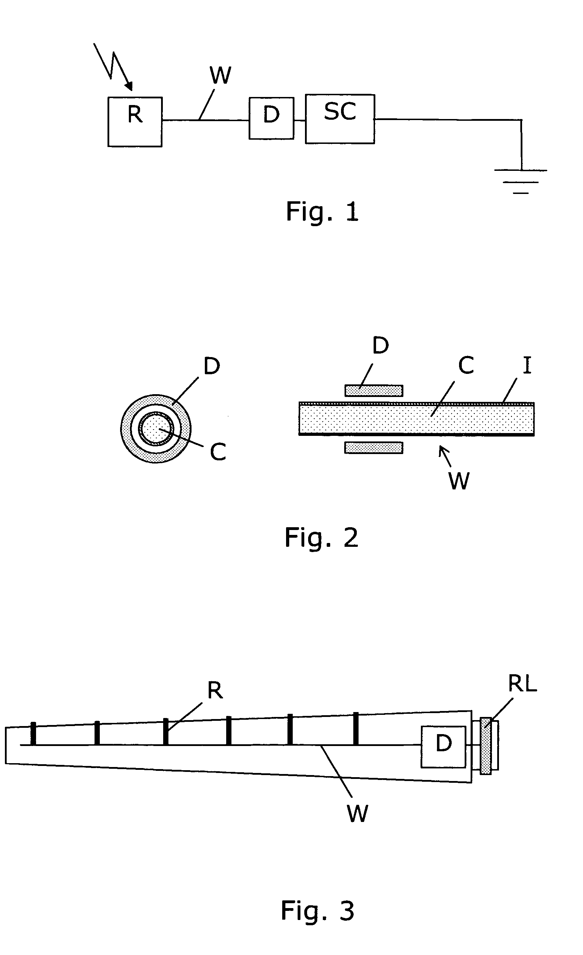

Fig. 1 illustrates rough diagram indicating the basic function of one embodiment of the invention. In a wind turbine, a lightning arrester system includes lightning receptors R positioned in the blades for capturing lightning, thereby ensuring that lightning will not strike and damage a vital part of the wind turbine. In general receptors may also be positioned at other parts of the wind turbine, e.g. on the nacelle. A down conductor serves to electrically connect the receptors R to electrical ground, e.g. an earth rod at the base of the wind turbine tower. The down conductor includes an electrical conductor W for electrically connecting the receptors R to a sliding contact arrangement SC serving to ensure electrical contact between different parts of the wind turbine can move in relation to each other, e.g. the blades in relation to the hub/spinner and the nacelle. Another electrical conductor serves to connect the other side of the sliding contact arrangement SC to electrical ground.

In general such sliding contact arrangement SC in the form of brushed or trolley shoe and rail arrangements will not provide a perfect continuous electrical conduction. Thus, static electrical discharges can build up in the blades and generate high voltage sparks across the sliding contact arrangement SC, thereby introducing current impulses in the down conductor. To reduce EM due to such impulses travelling along the down conductor, especially electrical conductor parts W in the blades, an EMRR device D is mounted on the electrical conductor part W, encircling the electrical conductor part W and thereby reducing EM radiation radiated from the down conductor. The most effective EM reduction is achieved by positioning the EMRR device D on the electrical conductor part W close to the sliding contact arrangement, i.e. close to where the electric impulses are generated. To most effectively reduce EM radiation from the down conductor, EMRR device D can be mounted on both sides of all sliding contact arrangements SC in the wind turbine. However, typically the major part of the total EM radiation from a wind turbine will be radiated from the down conductor parts in the blades, and thus the most effective EM reduction can be achieved by mounting an EMRR device D on the down conductor parts W in all blades, preferably as close as possible to the sliding contact arrangement SC electrically interconnecting the electrical conductor part W in the blade with the remaining part of the down conductor, such as illustrated in Fig. 1.

EMRR devices D are known and commercially available in different sizes and materials with different EMRR properties. Thus, EMRR devices D can be selected to fit the actual size of electrical conductor parts W and with EMRR properties adapted to reduce EM radiation in the most critical frequency range. Most often the frequency range 1-100 MHz is the most critical, but under special conditions the frequency range below 1 MHz or above 100 MHz may also require attenuation. To cover a large frequency range, the most effective EMRR effect may be obtained by mounting a plurality of different EMRR devices D close together, since some EMRR devices D are suited to provide effective attenuation in a rather narrow frequency range. E.g. a combination of solid body type EMRR devices D and choke coil type EMRR devices D may be used.

Examples of manufacturers of EMRR devices suitable for wind turbines are: Magnetec and Kitagawa. It is appreciated, however, that many other types of EMRR devices can be used.

Fig. 2 illustrates in a sectional and a cross sectional view a cylindrically shaped solid body type EMRR device D, e.g. of a nano-crystalline material, encircling a portion of a down conductor part W. As seen, the EMRR device D has an opening in the form of a circular through-going hole with a diameter larger than the electrical conductor C plus insulating layer I of the down conductor part W, thus leaving a small air gap around the down conductor part. In principle such air gap is not required, but it is required that the core material of the EMRR device D should not be in electrical contact with the conductor C of the down conductor part W.

To install the EMRR device D on an existing wind turbine may require dismantling of the down conductor part W in case the EMRR device D is in the form of a solid body. However, "snap-on" type of EMRR devices D are also commercially available, i.e. devices with EMRR material in two or more pieces e.g. cast into a plastic shell with a locking mechanism arranged for opening during installation, and when closed around the down conductor part, the EMRR material encircles the down conductor part. Such types can be used for add-on installation if dismantling of the down conductor part is complicated due to lack of space or if is too time consuming.

Fig. 3 illustrates a wind turbine blade with a preferred position of an EMRR device D. A plurality of lightning receptors R are positioned along the extension of the blade and electrically interconnected by a down conductor part W. At the base of the blade where it is arranged for mounting to a hub/spinner, the down conductor part W is electrically connected to an electrically conducting rail RL serving as part of a sliding contact arrangement which can allow the blade to rotate in relation to the hub/spinner when installed thus allowing pitch adjustment. An EMRR device D is mounted encircling the down conductor part W inside the blade structure, thus being protected by the blade structure, and as close to the electrically conductive rail RL as practically possible.

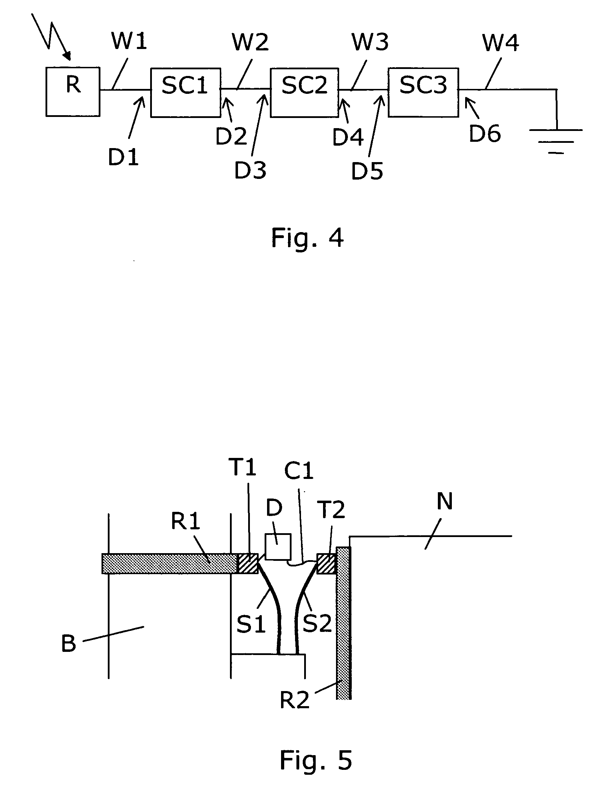

Fig. 4 illustrates a diagram of a lightning arrester system embodiment in a wind turbine in which the down conductor includes a plurality of electrical conductor parts W1, W2, W3, W4 serving to electrically connect a lightning receptor R to electrical ground via a plurality of sliding contact arrangements SC1, SC2, SC3 that are positioned so at to allow the receptor R to be electrically connected to electrical ground at the base of the wind turbine tower through the blades, hub/spinner, nacelle and tower and still allow these parts to move in relation to each other. Especially, W1 is an electrical conductor in the blade, SC1 connect the blade electrical conductor W1 to an electrical conductor W2 in the hub/spinner. SC2 then connects W2 in the hub/spinner to electrical conductor W3 in the nacelle. SC3 connects electrical conductor W3 in the nacelle with electrical conductor W4 placed inside the tower, or with electrical conductor W4 being formed by the metal tower itself. Finally, the electrical conductor W4 can be connected to an earth rod for electrically terminating the down conductor at electrical ground.

The arrows D1, D2, D3, D4, D5, and D6 indicate possible position for mounting of EMRR devices on the down conductor. Depending on the structure of the wind turbine and the desired level of EM radiation attenuation, one, several or all of these positions can be used for mounting of EMRR devices.

Fig. 5 illustrates a detail sketch of an alternative position of an EMRR device D in a specific sliding contact arrangement. The sliding contact arrangement electrically interconnects an electrically conducting rail R1 mounted to the blade B with electrically conducting rail R2 mounted in the nacelle N via electrically conducting trolley shoes T1 and T2 forced into contact with respective rails R1 and R2 by means of respective spring members S1 and S2. The trolley shoes T1 and T2 are electrically connected via an intermediate electrical conductor C1. In this embodiment, the EMRR device D is mounted encircling the intermediate electrical conductor C1. Using this intermediate electrical conductor C1 for mounting of an EMRR device D, the EMRR device is mounted on a typically rather easily accessible part of the down conductor, and thus this intermediate electrical conductor C1 is suitable for add-on mounting of an EMRR device. Further, being an electrical conductor of limited length, the intermediate electrical conductor C1 can easily be replaced by another prepared electrical conductor component with an EM reduction device D mounted thereon, and thus the EMRR device D can be installed very quickly with a very limited down period of the wind turbine.

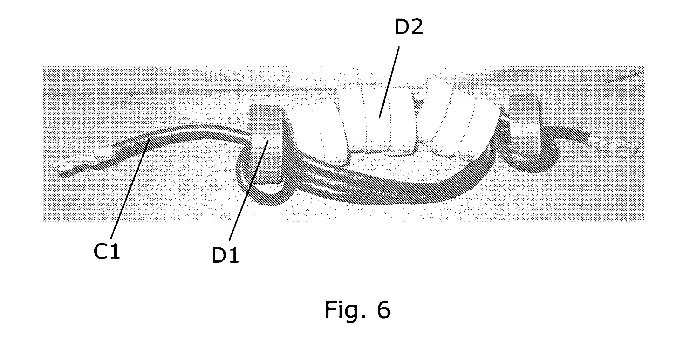

Fig. 6 shows a photo of a specific example of an intermediate electrical conductor C1 with a plurality of cylindrically shaped EMRR devices D1, D2 mounted encircling the intermediate electrical conductor C1. As seen, two different types of EMRR devices with different EMRR properties are used, namely two dark shaped ones D1 and 8 light shaded ones D2. The use of several single EMRR devices close together ensures that effectively, a substantial length of the electrical conductor is encircled, thus increasing the EMRR efficiency. The photo shows that the intermediate electrical conductor C1 is looped a plurality of times around the EMRR devices D1, D2, the electrical conductor C1 passing around and through respective through-going holes in the EMRR devices D1, D2. In this way the EMRR devices D1, D2 each encircles a plurality of portions of the electrical conductor C1. This looping which provides a higher EMRR effect compared to the EMRR device merely encircling the electrical conductor C1 once.

To sum up: the invention provides a wind turbine with a lightning arrester system including one or more lightning receptors mounted on one or more rotor blades. A down conductor electrically connects one or more lightning receptors R to electrical ground via a sliding contact arrangement, and an EMRR device encircles a portion of the down conductor so as to reduce EM radiation from the down conductor. Such wind turbine will have a low EM radiation, since electric impulses in the down conductor are attenuated by such EMRR devices. Such electric impulses can be created because of static electric discharges caused by imperfect electric contact in the sliding contact arrangement. Known types of EMRR devices in the form of commercially available common mode choke coils, cylindrically shaped nano-crystalline solid body types, or the like, can be used. A plurality of different types with different EMRR properties can be used in combination. To obtain more effective EM radiation reduction, a plurality of EMRR devices can be used, e.g. positioned at several portions of the down conductor, especially close to sliding contact arrangements. A preferred position of an EMRR device D is on a down conductor part W in each of the rotor blades, at an end of the electrical conductor W facing the sliding contact arrangement RL serving to electrically connect the electrical conductor W to electrical ground.

Although the present invention has been described in connection with the specified embodiments, it should not be construed as being in any way limited to the presented examples. The scope of the present invention is to be interpreted in the light of the accompanying claim set.

## Claims

1. A wind turbine including
- one or more rotor blades arranged for rotation in relation to a nacelle,
- a tower arranged for carrying the nacelle, and
- a lightning arrester system including
- one or more lightning receptors (R) mounted on the one or more rotor blades,
- a down conductor (W) arranged for electrically connecting the one or more lightning receptors (R) to electrical ground, the down conductor including a first sliding contact arrangement (SC), and **characterised by**
- an electromagnetic radiation reduction device (D) encircling a portion of the down conductor (W) so as to reduce electromagnetic radiation from the down conductor.

2. Wind turbine according to claim 1, including a plurality of separate electromagnetic radiation reduction devices (D) encircling different portions of the down conductor.

3. Wind turbine according to claim 1 or 2, wherein at least one electromagnetic radiation reduction device is arranged on an end part of an electrical conductor portion (C) of the down conductor facing the first sliding contact arrangement (SC1).

4. Wind turbine according to claim 2, wherein the plurality of separate electromagnetic radiation reduction devices includes at least two different types of reduction devices (D1, D2) with different electromagnetic radiation reduction properties.

5. Wind turbine according to any of claims 1-4, wherein the electromagnetic radiation reduction device (D) is a coil with a plurality of windings arranged for encircling a portion of the down conductor. (W)

6. Wind turbine according to any of the preceding claims, wherein the down conductor (W) includes a first electrical conductor (W1) arranged in a rotor blade, the first electrical conductor interconnecting the one or more lightning receptors (R) and the first sliding contact arrangement (SC1) for electrically connecting the first electrical conductor (W1) to a second electrical conductor (W2), and wherein a first electromagnetic radiation reduction device (D1) encircles a portion of the first electrical conductor (W1), preferably an end portion of the first electrical conductor facing the first sliding contact arrangement (SC1).

7. Wind turbine according to claim 6, wherein a second electromagnetic radiation reduction device (D2) is mounted on the second electrical conductor (W2), preferably at an end portion of the second electrical conductor facing the first sliding contact arrangement (SC1).

8. Wind turbine according to any of the preceding claims, wherein the first sliding contact arrangement (SC1) includes two sliding contacts interconnected by an intermediate electrical conductors (C1), and wherein an electromagnetic radiation reduction device (D) encircles the intermediate electrical conductor (C1).

9. Wind turbine according to claim 6 or 7, including a second sliding contact arrangement (SC2) interconnecting the second electrical conductor (W2) and a third electrical conductor (W3) of the down conductor (W), wherein an electromagnetic radiation reduction device (D4) is mounted on the third electrical conductor (W3), preferably at an end portion of the third electrical conductor facing the second sliding contact arrangement (SC2).

10. Wind turbine according to claim 9, including a third sliding contact arrangement (SC3) interconnecting the third electrical conductor (W3) and a fourth electrical conductor (W4) of the down conductor, wherein an electromagnetic radiation reduction device (D4) is mounted on the fourth electrical conductor (W4), preferably at an end portion of the fourth electrical conductor facing the third sliding contact arrangement (SC3)

11. Wind turbine according to any of the preceding claims, wherein the down conductor is looped a plurality of times around the electromagnetic radiation reduction device, the down conductor passing around a portion of and through a through-going hole in the electromagnetic radiation reduction device, such that the electromagnetic radiation reduction device encircles a plurality of portions of the down conductor.

12. Wind turbine according to claim 11, wherein the down conductor is looped a plurality of times around a plurality of electromagnetic radiation reduction devices (D1, D2), the down conductor passing around a portion of and through respective through-going holes in said plurality of electromagnetic radiation reduction devices.

13. A method of reducing electromagnetic radiation from a wind turbine, where the wind turbine includes at least two rotor blades arranged for rotation in relation to a nacelle, a tower arranged for carrying the nacelle, and a lightning arrester system including one or more lightning receptors (R) mounted on the one or more rotor blades as well as a down conductor (W) arranged for electrically connecting the one or more lightning receptors to electrical ground, and where the down conductor includes a sliding contact arrangement (SC), wherein the method is **characterised by** arranging an electromagnetic radiation reduction device (D) relative to the down conductor (W) so that at least a portion of the down conductor is encircled by the electromagnetic radiation device (D).

14. A method according to claim 13, wherein the electromagnetic radiation reduction device is arranged to encircle a portion of the down conductor, said portion being located adjacent to the sliding contact (SC) arrangement.

## Patentansprüche

1. Windkraftanlage, umfassend
- ein oder mehrere Rotorblätter, vorgesehen zur Drehung im Verhältnis zu einer Gondel,
- einen Turm, vorgesehen zum Tragen der Gondel und
- ein Blitzableitersystem, umfassend
- einen oder mehrere Blitzrezeptoren (R), die an dem einen oder den mehreren Rotorblättern angebracht sind,
- einen Ableiter (W), der für die elektrische Masseverbindung des einen oder der mehreren Blitzrezeptoren (R) vorgesehen ist, wobei der Ableiter eine erste Gleitkontaktanordnung (SC) umfasst, und **dadurch gekennzeichnet, dass**
- eine Vorrichtung zur Reduzierung elektromagnetischer Strahlung (D) einen Abschnitt des Ableiters (W) umschließt, um die elektromagnetische Strahlung des Ableiters zu reduzieren.

2. Windkraftanlage nach Anspruch 1, umfassend eine Mehrzahl von getrennten Vorrichtungen zur Reduzierung elektromagnetischer Strahlung (D), die unterschiedliche Abschnitte des Ableiters umschließen.

3. Windkraftanlage nach Anspruch 1 oder 2, wobei mindestens eine Vorrichtung zur Reduzierung elektromagnetischer Strahlung an einem Endteil eines Abschnitts eines elektrischen Leiters (C) des Ableiters gegenüber der ersten Gleitkontaktanordnung (SC1) vorgesehen ist.

4. Windkraftanlage nach Anspruch 2, wobei die Mehrzahl von getrennten Vorrichtungen zur Reduzierung elektromagnetischer Strahlung mindestens zwei unterschiedliche Typen von Reduzierungsvorrichtungen (D1, D2) mit unterschiedlichen Eigenschaften zur Reduzierung elektromagnetischer Strahlung umfasst.

5. Windkraftanlage nach einem der Ansprüche 1-4, wobei die Vorrichtung zur Reduzierung elektromagnetischer Strahlung (D) eine Spule mit einer Mehrzahl von Wicklungen ist, die zum Umschließen eines Abschnitts des Ableiters (W) vorgesehen ist.

6. Windkraftanlage nach einem der vorhergehenden Ansprüche, wobei der Ableiter (W) einen ersten elektrischen Leiter (W1), der in einem Rotorblatt vorgesehen ist, umfasst, wobei der erste elektrische Leiter den einen oder die mehreren Blitzrezeptoren (R) mit der ersten Gleitkontaktanordnung (SC1) zur Schaffung einer elektrischen Verbindung des ersten elektrischen Leiters (W1) mit einem zweiten elektrischen Leiter (W2) verbindet, und wobei eine erste Vorrichtung zur Reduzierung elektromagnetischer Strahlung (D1) einen Abschnitt des ersten elektrischen Leiters (W1), vorzugsweise einen Endabschnitt des ersten elektrischen Leiters gegenüber der ersten Gleitkontaktanordnung (SC1), umschließt.

7. Windkraftanlage nach Anspruch 6, wobei eine zweite Vorrichtung zur Reduzierung elektromagnetischer Strahlung (D2) an dem zweiten elektrischen Leiter (W2), vorzugsweise an einem Endabschnitt des zweiten elektrischen Leiters gegenüber der ersten Gleitkontaktanordnung (SC1), angebracht ist.

8. Windkraftanlage nach einem der vorhergehenden Ansprüche, wobei die erste Gleitkontaktanordnung (SC1) zwei Gleitkontakte umfasst, die durch einen dazwischenliegenden elektrischen Leiter (C1) miteinander verbunden sind, und wobei eine Vorrichtung zur Reduzierung elektromagnetischer Strahlung (D) den dazwischenliegenden elektrischen Leiter (C1) umschließt.

9. Windkraftanlage nach Anspruch 6 oder 7, umfassend eine zweite Gleitkontaktanordnung (SC2), die den zweiten elektrischen Leiter (W2) und einen dritten elektrischen Leiter (W3) des Ableiters (W) miteinander verbindet, wobei eine Vorrichtung zur Reduzierung elektromagnetischer Strahlung (D4) an dem dritten elektrischen Leiter (W3), vorzugsweise an einem Endabschnitt des dritten elektrischen Leiters gegenüber der zweiten Gleitkontaktanordnung (SC2), angebracht ist.

10. Windkraftanlage nach Anspruch 9, umfassend eine dritte Gleitkontaktanordnung (SC3), die den dritten elektrischen Leiter (W3) und einen vierten elektrischen Leiter (W4) des Ableiters (W) miteinander verbindet, wobei eine Vorrichtung zur Reduzierung elektromagnetischer Strahlung (D6) an dem vierten elektrischen Leiter (W4), vorzugsweise an einem Endabschnitt des vierten elektrischen Leiters gegenüber der dritten Gleitkontaktanordnung (SC3), angebracht ist.

11. Windkraftanlage nach einem der vorhergehenden Ansprüche, wobei der Ableiter mehrmals um die Vorrichtung zur Reduzierung elektromagnetischer Strahlung gewunden ist, wobei der Ableiter um einen Abschnitt und durch eine Durchgangsöffnung der Vorrichtung zur Reduzierung elektromagnetischer Strahlung geführt wird, sodass die Vorrichtung zur Reduzierung elektromagnetischer Strahlung eine Mehrzahl von Abschnitten des Ableiters umschließt.

12. Windkraftanlage nach Anspruch 11, wobei der Amtsleiter mehrmals um eine Mehrzahl von Vorrichtungen zur Reduzierung elektromagnetischer Strahlung (D1, D2) gewunden ist, wobei der Ableiter um einen Abschnitt und durch die Mehrzahl der Vorrichtungen zur Reduzierung elektromagnetischer Strahlung bzw. Durchgangsöffnungen davon geführt wird.

13. Verfahren zur Reduzierung elektromagnetischer Strahlung einer Windkraftanlage, wobei die Windkraftanlage mindestens zwei Rotorblätter, vorgesehen zur Drehung im Verhältnis zu einer Gondel, einen Turm, vorgesehen zum Tragen der Gondel und ein Blitzableitersystem mit einem oder mehreren Blitzrezeptoren (R), die an dem einen oder den mehreren Rotorblättern angebracht sind, sowie einem Ableiter (W), vorgesehen für die elektrische Masseverbindung des einen oder der mehreren Blitzrezeptoren (R), umfasst, wobei der Ableiter eine erste Gleitkontaktanordnung (SC) umfasst, wobei das Verfahren **dadurch gekennzeichnet ist, dass** eine Vorrichtung zur Reduzierung elektromagnetischer Strahlung (D) im Verhältnis zu dem Ableiter (W) vorgesehen ist, sodass mindestens ein Abschnitt des Ableiters von der Vorrichtung zur Reduzierung elektromagnetischer Strahlung (D) umschlossen ist.

14. Verfahren nach Anspruch 13, wobei die Vorrichtung zur Reduzierung elektromagnetischer Strahlung zum Umschließen eines Abschnitts des Ableiters vorgesehen ist, wobei sich der Abschnitt neben der Gleichkontaktanordnung (SC) befindet.

## Revendications

1. Turbine éolienne comprenant
- une ou plusieurs pales de rotor disposées pour tourner par rapport à une nacelle,
- une tour disposée pour supporter la nacelle, et
- un système parafoudre comprenant
- un ou plusieurs récepteurs de foudre (R) montés sur les une ou plusieurs pales de rotor,
- un conducteur de descente (W) disposé pour raccorder électriquement les un ou plusieurs récepteurs de foudre (R) à la mise à la terre électrique, le conducteur de descente comprenant un premier système de contact glissant (SC), et **caractérisé par**
- un dispositif réducteur de rayonnement électromagnétique (D) entourant une portion du conducteur de descente (W) de manière à réduire le rayonnement électromagnétique provenant du conducteur de descente.

2. Turbine éolienne selon la revendication 1, comprenant une pluralité de dispositifs réducteurs de rayonnement électromagnétique (D) distincts entourant différentes portions du conducteur de descente.

3. Turbine éolienne selon la revendication 1 ou 2, dans laquelle au moins un dispositif réducteur de rayonnement électromagnétique est disposé sur une portion d'extrémité d'une portion électriquement conductrice (C) du conducteur de descente située face au premier système de contact glissant (SC1).

4. Turbine éolienne selon la revendication 2, dans laquelle la pluralité de dispositifs réducteurs de rayonnement électromagnétique distincts comprend au moins deux types différents de dispositifs réducteurs (D1, D2) possédant des propriétés de réduction du rayonnement électromagnétique différentes.

5. Turbine éolienne selon l'une quelconque des revendications 1 à 4, dans laquelle le dispositif réducteur de rayonnement électromagnétique (D) est une bobine possédant plusieurs enroulements disposés pour entourer une portion du conducteur de descente (W).

6. Turbine éolienne selon l'une quelconque des revendications précédentes, dans laquelle le conducteur de descente (W) comprend un premier conducteur électrique (W1) disposé dans une pale de rotor, le premier conducteur électrique reliant les un ou plusieurs récepteurs de foudre (R) au premier système de contact glissant (SC1) pour raccorder électriquement le premier conducteur électrique (W1) à un deuxième conducteur électrique (W2), et dans laquelle un premier dispositif réducteur de rayonnement électromagnétique (D1) entoure une portion du premier conducteur électrique (W1), de préférence une portion d'extrémité du premier conducteur électrique située face au premier système de contact glissant (SC1).

7. Turbine éolienne selon la revendication 6, dans laquelle un deuxième dispositif réducteur de rayonnement électromagnétique (D2) est monté sur le deuxième conducteur électrique (W2), de préférence au niveau d'une portion d'extrémité du deuxième conducteur électrique située face au premier système de contact glissant (SC1).

8. Turbine éolienne selon l'une quelconque des revendications précédentes, dans laquelle le premier système de contact glissant (SC1) comprend deux contacts glissants reliés par un conducteur électrique intermédiaire (C1), et dans laquelle un dispositif réducteur de rayonnement électromagnétique (D) entoure le conducteur électrique intermédiaire (C1).

9. Turbine éolienne selon la revendication 6 ou 7, comprenant un deuxième système de contact glissant (SC2) reliant le deuxième conducteur électrique (W2) à un troisième conducteur électrique (W3) du conducteur de descente (W), dans laquelle un dispositif réducteur de rayonnement électromagnétique (D4) est monté sur le troisième conducteur électrique (W3), de préférence au niveau d'une portion d'extrémité du troisième conducteur électrique située face au deuxième système de contact glissant (SC2).

10. Turbine éolienne selon la revendication 9, comprenant un troisième système de contact glissant (SC3) reliant le troisième conducteur électrique (W3) à un quatrième conducteur électrique (W4) du conducteur de descente, dans laquelle un dispositif réducteur de rayonnement électromagnétique (D6) est monté sur le quatrième conducteur électrique (W4), de préférence au niveau d'une portion d'extrémité du quatrième conducteur électrique située face au troisième système de contact glissant (SC3).

11. Turbine éolienne selon l'une quelconque des revendications précédentes, dans laquelle le conducteur de descente forme plusieurs boucles autour du dispositif réducteur de rayonnement électromagnétique, le conducteur de descente passant autour d'une portion du dispositif réducteur de rayonnement électromagnétique et au travers d'un trou traversant celui-ci, de manière à ce que le dispositif réducteur de rayonnement électromagnétique entoure plusieurs portions du conducteur de descente.

12. Turbine éolienne selon la revendication 11, dans laquelle le conducteur de descente forme plusieurs boucles autour de plusieurs dispositifs réducteurs de rayonnement électromagnétique (D1, D2), le conducteur de descente passant autour d'une portion desdits plusieurs dispositifs réducteurs de rayonnement électromagnétique et dans des trous respectifs traversant ceux-ci.

13. Méthode de réduction du rayonnement électromagnétique provenant d'une turbine éolienne, où la turbine éolienne comprend au moins deux pales de rotor disposées pour tourner par rapport à une nacelle, une tour disposée pour supporter la nacelle et un système parafoudre comprenant un ou plusieurs récepteurs de foudre (R) montés sur les une ou plusieurs pales de rotor ainsi qu'un conducteur de descente (W) disposé pour raccorder électriquement les un ou plusieurs récepteurs de foudre à la mise à la terre électrique, et où le conducteur de descente comprend un système de contact glissant (SC), dans laquelle la méthode est **caractérisée par** la disposition d'un dispositif réducteur de rayonnement électromagnétique (D) par rapport au conducteur de descente (W) de manière à ce qu'au moins une portion du conducteur de descente soit entourée par le dispositif réducteur de rayonnement électromagnétique (D).

14. Méthode selon la revendication 13, dans laquelle le dispositif réducteur de rayonnement électromagnétique est disposé pour entourer une portion du conducteur de descente, ladite portion étant adjacente au système de contact glissant (SC).
